# EUROPÄISCHE PATENTANMELDUNG

(11) **EP 0 604 841 A1**
(43) Veröffentlichungstag der Anmeldung: **06.07.1994**
(21) Anmeldenummer: 93120260.0
(22) Anmeldetag: 16.12.1993
(51) Int. Cl.: G02F 1/35

(54) **Verfahren zur Herstellung von strukturierten Polymerschichten mit nichtlinear optischen Eigenschaften**

(30) Priorität: 24.12.1992 DE 4244195
(71) Anmelder: BASF Aktiengesellschaft, D-67063 Ludwigshafen (DE)
(72) Erfinder: Etzbach, Karl-Heinz, Dr., D-67227 Frankenthal (DE); Kilburg, Heike, Dr., D-67346 Speyer (DE); Lorkowski, Hans-Joachim, Prof. Dr., D-13156 Berlin (DE); Pfeiffer, Karl, Dr., D-12489 Berlin (DE)

(57) **Zusammenfassung**

Die Erfindung betrifft ein Verfahren zur Herstellung von strukturierten Polymerschichten mit nichtlinear optischen Eigenschaften, wobei man entweder ethylenisch ungesättigte Gruppierungen enthaltende organische Verbindungen mit ethylenisch ungesättigte Gruppierungen sowie Donator- und Acceptorgruppen enthaltenden Stilben-, Azo- oder Azomethinverbindungen radikalisch copolymerisiert (A) oder ethylenisch ungesättigte Gruppierungen enthaltende organische Verbindungen radikalisch polymerisiert und mit ethylenisch ungesättigte Gruppierungen sowie Donator- und Acceptorgruppen enthaltenden Stilben-, Azo- oder Azomethinverbindungen vermischt (B), die so erhaltenen Copolymerisate (A) oder Gemische (B) mit hochenergetischer Strahlung bildmäßig bestrahlt, die unbestrahlten Bereiche entfernt und die so erhaltenen strukturierten Polymerschichten im elektrischen Feld zur Orientierung der chromophoren Struktureinheiten im Bereich der Glastemperatur des Polymers polt und bei angelegtem elektrischen Feld vernetzt.

Derartige strukturierte Polymerschichten eignen sich zur Herstellung polymerer Wellenleiter in der Kommunikationstechnik.

## Beschreibung

Die Erfindung betrifft ein Verfahren zur Herstellung strukturierter Polymerschichten mit nichtlinear optischen Eigenschaften durch bildmäßige Bestrahlung der Schicht mit hochenergetischer Strahlung, anschließender Strukturentwicklung, elektrischer Polung und Vernetzung.

Es ist bekannt, daß Materialien, die nichtlinear optische Eigenschaften zeigen, eine feldstärkenabhängige dielektrische Suszeptibilität aufweisen. Organische Polymere erhalten diese Eigenschaften durch Polung hyperpolarisierbarer Strukturelemente im elektrischen Feld. Die zur Zeit bekannten organischen Polymermaterialien zeigen noch unbefriedigende nichtlinear optische Eigenschaften und werden den gestellten Anforderungen nicht gerecht. Dies betrifft insbesondere die bisher noch unzureichende Eigenschaftsstabilität. Zur Verminderung der Relaxation des durch Polung erreichbaren orientierten Zustandes von chromophoren Strukturen wird die photochemische Vernetzung benutzt, indem photosensitive chromophore Strukturelemente mittels UV-Strahlung photochemisch vernetzt werden (vgl. B.K. Mandal et al., Appl. Phys. Letters 58 (1991) 2459, Makromol. Chem. Rapid. Commun. 12 (1991) 63). Durch die Trennung der beiden Prozesse, Orientierung chromophorer Strukturen im elektrischen Feld im Bereich der Glastemperatur des Polymersystems und separate Vernetzung wird ein höherer Orientierungsgrad bei wesentlich kürzeren Polungszeiten im elektrischen Feld erreicht als bei einem Simultanprozeß, wie dies z. B. bei einem Prepolymeren aus bifunktionellen Epoxydmonomeren und aromatischen, chromophoren einen der Fall ist (vgl. M. Eich et al., J. Appl. Phys. 66 (1989) 3241, D. Jungbauer et al., Phys. Letters 56 (1990) 2610, bzw. EP-0313475-A2). Die Hauptnachteile dieser Verfahrensweisen bestehen darin, daß im ersten Falle lange UV-Bestrahlungszeiten erforderlich sind, um einen hohen Vernetzungsgrad zur Verminderung der Relaxation des orientierten Zustandes zu erreichen, wodurch mehr oder weniger stark die chromophore Struktureinheit zerstört wird und bei der thermischen Vernetzung im zweiten Fall sehr lange Polungszeiten erforderlich sind und eine erschwerte Prozeßkontrolle durch die sich ständig ändernde Struktur während der Polung besteht. Hinzu kommt, daß eine strukturierbare Polymerschicht nach dieser Verfahrensweise nicht zu realisieren ist.

Die Aufgabe der vorliegenden Erfindung besteht darin, ein Verfahren zur Herstellung einer nichtlinear optischen Polymerschicht aufzufinden, bei dem eine Orientierung der hyperpolarisierbaren Strukturelemente im Polymeren während der Polung im elektrischen Feld durch eine Vernetzung nicht behindert wird und der erreichte Orientierungszustand durch strahlungschemische Vernetzung stabilisiert und strukturmäßig erzeugt werden kann.

Diese Aufgabe läßt sich erfindungsgemäß dadurch lösen, daß eine strahlungsempfindliche Polymerschicht, die hyperpolarisierbare Struktureinheiten enthält, mit hochenergetischer Strahlung bildmäßig bestrahlt, die unbestrahlten Bereiche entfernt, anschließend eine Orientierung der hyperpolarisierbaren Struktureinheiten, die entweder in dotierter Form, d. h. als Gemischbestandteil, oder kovalent gebunden in der Polymermatrix vorliegen, im elektrischen Feld vorgenommen und danach vernetzt wird.

Gegenstand der vorliegenden Erfindung ist ein Verfahren zur Herstellung von strukturierten Polymerschichten mit nichtlinear optischen Eigenschaften, das dadurch gekennzeichnet ist, daß man entweder ethylenisch ungesättigte Gruppierungen enthaltende organische Verbindungen mit ethylenisch ungesättigte Gruppierungen sowie Donator- und Acceptorgruppen enthaltenden Stilben-, Azo- oder Azomethinverbindungen radikalisch copolymerisiert (A) oder ethylenisch ungesättigte Gruppierungen enthaltende organische Verbindungen radikalisch polymerisiert und mit ethylenisch ungesättigte Gruppierungen sowie Donator- und Acceptorgruppen enthaltenden Stilben-, Azo- oder Azomethinverbindungen vermischt (B), die so erhaltenen Copolymerisate (A) oder Gemische (B) mit hochenergetischer Strahlung bildmäßig bestrahlt, die unbestrahlten Bereiche entfernt und die so erhaltenen strukturierten Polymerschichten im elektrischen Feld zur Orientierung der chromophoren Struktureinheiten im Bereich der Glastemperatur des Polymers polt und bei angelegtem elektrischen Feld vernetzt.

Als hochenergetische Strahlung können hierzu beispielsweise Elektronen-, Röntgen- oder Ionenstrahlung eingesetzt werden.

Bevorzugt zur Herstellung der Copolymerisate (A) bzw. der Gemische (B) werden Methacrylsäureglycidylester oder mehrfunktionelle aromatische Diallylester, insbesondere Benzoldicarbonsäurediallylester eingesetzt.

Die Entfernung der unbestrahlten Bereiche nach der bildmäßigen Bestrahlung erfolgt vorzugsweise durch Herauslösen mit organischem Lösungsmittel und Entfernung restlichen Lösungsmittels.

Bevorzugte ist ferner, daß die Vernetzung bei angelegtem elektrischen Feld strahlenchemisch erfolgt.

Gegenstand der vorliegenden Erfindung ist auch ein Verfahren zur Weiterverarbeitung strukturierter Polymerschichten mit nichtlinear optischen Eigenschaften zu optischen Wellenleitern, wobei die erfindungsgemäß hergestellten strukturierten Polymerschichten vor oder nach der Polung im elektrischen Feld und Vernetzung durch Aufbringen eines Copolymerisats aus Methacrylsäuremethylester und Methacrylsäure, wobei der Methacrylsäureanteil im Copolymerisat > 30 Mol.-% beträgt, eingeebnet werden.

Das nichtlinear optische Verhalten der erfindungsgemäß hergestellten Polymerschichten hat eine Reihe von Effekten zur Folge, die von großem anwendungstechnischen Interesse für Bauelemente in der integrierten Optik, wie optische Wellenleiter und elektrooptische Modulatoren sind, so daß sich die erfindungsgemäß hergestellten strukturierten Polymerschichten mit nichtlinear optischen Eigenschaften für die Herstellung polymerer Wellenleiter in der Kommunikationstechnik, Optoelektronik und optischen Signalverarbeitung anwendbar sind.

Zum erfindungsgemäßen Verfahren ist im einzelnen folgendes auszuführen.

Für das erfindungsgemäße Verfahren können sowohl ethylenisch ungesättigte Gruppierungen enthaltende organische Verbindungen, wie z. B. Acryl- oder Methacrylverbindungen, vorzugsweise mehrfunktionelle Acryl- oder Methacrylverbindungen, wie Glycidylacrylat oder insbesondere Glycidylmethacrylat oder mehrfunktionelle ethylenisch ungesättigte aromatische Verbindungen, wie z. B. Phthalsäure-, Isophthalsäure- oder Terephthalsäurediallylester, mit ethylenisch ungesättigte Gruppierungen sowie Donator- und Acceptorgruppen enthaltenden Stilben-, Azo- oder Azomethinverbindungen, also ethylenisch ungesättigten chromophoren Verbindungen, wie z. B. derartigen chromophore Gruppen tragenden (Meth)acrylestern, radikalisch copolymerisiert werden (= A), als auch dotierte Polymermatrices (= B) eingesetzt werden, d. h. Gemische aus Homo- oder Copolymeren ethylenisch ungesättigter organischer Verbindungen, wie z. B. (Meth)acrylathomo- oder -copolymerisate, wie z.B. von Methacrylsäureallylester und/oder Glycidylmethacrylat, oder Prepolymeren ethylenisch ungesättigter aromatischer Verbindungen, wie z. B. auf Basis mehrfunktioneller aromatischer Allylester, z. B. auf Basis von Phthalsäure-, Isophthalsäure- und/oder Terephthalsäurediallylester mit ethylenisch ungesättigte Gruppierungen sowie Donator- und Acceptorgruppen enthaltenden chromophoren Verbindungen aus der Gruppe der Stilben-, Azo- oder Azomethinverbindungen.

Die als bevorzugte Beispiele anzuführenden Homo- bzw. Copolymerisate auf der Basis von Glycidylmethacrylat (PGMA) bzw. mehrfunktionellen aromatischen Prepolymeren auf der Grundlage von Phthalsäure-, Isophthalsäure- und Terephthalsäurediallylestern besitzen also chromophore Struktureinheiten durch Dotierung oder Copolymerisation .

Durch die hohe Strahlungsempfindlichkeit der verwendeten Polymerisate gegenüber Elektronen- und Röntgenstrahlen ist nur eine geringe Bestrahlungsdosis erforderlich, um eine für die Strukturierung notwendige Löslichkeitsänderung zu erzielen. Bei einer Dotierung bis zu 15 Gew.-% an Chromophoren mit einem ausgedehnten π-Elektronensystem wie z. B. unsubstituierte und substituierte Stilbene, Azo- und Azomethine mit Donator-(Dialkylamino-) und Acceptorgruppen (NO₂-) ergibt sich bei einer Elektronenstrahldosis von <10 µC/cm² (20 KeV) bei Polyglycidylmethacrylaten und bei <50 µC/cm² (20 KeV) beim Polydiallylphthalat (PDAP) als Wirtspolymer ein Erhalt der Ausgangsschicht von > 80 % bei einer Strukturentwicklung mit Methylethylketon oder Methylisobutylketon. Das gleiche Ergebnis wird bei einem Copolymeren aus 30 Gew.-% einer chromophoren Azoverbindung von 70 Gew.-% Glycidylmethacrylat erzielt.

Prinzipiell können die unterschiedlichsten hyperpolarisierbaren Verbindungen eingesetzt werden. Voraussetzung ist, daß diese Verbindungen eine sehr gute Verträglichkeit zur Polymermatrix bei der Dotierung besitzen, bzw. ein gutes Copolymerisationsverhalten aufweisen. Glycidylmethacrylat besitzt gegenüber polymerisationsfähigen chromophoren Verbindungen im allgemeinen eine bessere Copolymerisationsneigung als die Diallylester der isomeren Benzoldicarbonsäuren. Gegenüber Dotierungen erweisen sich die Prepolymeren der aromatischen Diallylester als günstiger. Dies ist auf die vergleichbare aromatische Struktur und auf die um eine Größenordnung geringere Molmasse der aromatischen Prepolymeren zurückzuführen. Letzteres ermöglicht die Herstellung von höheren Schichtdicken (> 1 µm) durch Einfachbeschichtung.

Beispiele für Azo-chromophore enthaltende ethylenisch ungesättigte Verbindungen sind u.a. 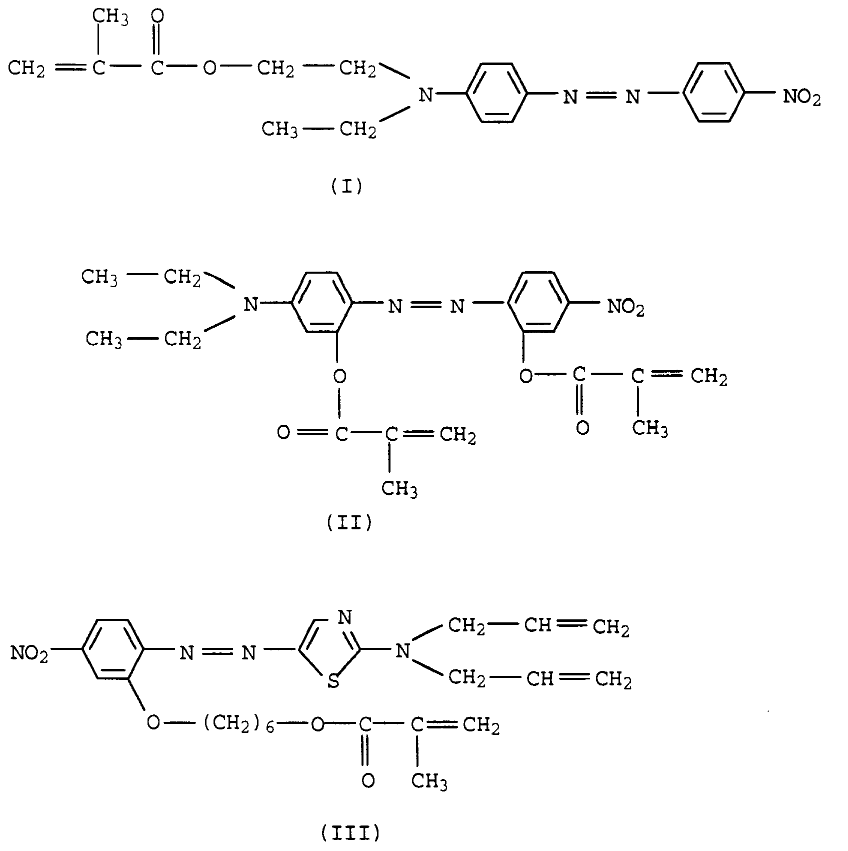
Die radikalische Homo- bzw. Copolymerisation der ethylenisch ungesättigten Verbindungen erfolgt auf übliche Weise, beispielsweise in Gegenwart von radikalliefernden Polymerisationskatalysatoren, wie Azoisobuttersäuredinitril (= AIBN) oder Benzoylperoxid, gegebenenfalls in geeigneten organischen Lösungsmitteln, wie Ketonen, z. B. Aceton oder Methylethylketon, vorzugsweise in einer Inertgasatmosphäre, z. B. N₂ oder Argon, bei Temperaturen zwischen 60 und 80°C. Die erhaltenen Homo- bzw. Copolymerisate können auf übliche Weise, wie durch Fällen ihrer Lösungen, beispielsweise durch ein- oder mehrmaliges Fällen ihrer acetonischen Lösungen in Methanol gereinigt werden.

Zur Weiterführung des erfindungsgemäßen Verfahrens werden die Copolymerisate (A) oder die Gemische (B) in Form ihrer Lösungen, beispielsweise in einem organischen Lösungsmittel, wie Cyclohexanon oder Ethylglykolacetat gelöst, durch einen Filter einer Porengröße von ca. 0,2 µm filtriert und auf ein geeignetes Substrat mittels Rotationsbeschichtung (bei ca. 500 bis 3000 U/min) aufgetragen und das Lösungsmittel entfernt. Als Substrate eignen sich übliche Substratmaterialien, wie z.B. Glas, Quarz, ITO-Substrate oder Metall. Die so beschichteten Substrate werden dann mit hochenergetischen Strahlen, beispielsweise mit Elektronenstrahlen (Energie 5 bis 50 KeV bzw. Dosis 5 bis 100 µC/cm²) bildmäßig bestrahlt, z. B. unter Verwendung einer Chrom-Maske. Anschließend wird entwickelt, d. h. die unbestrahlten Bereiche werden mit einem organischen Lösungsmittel, z. B. mit Methylethylketon, entfernt und kurz thermisch, z. B. bei 50 bis 100°C behandelt bzw. getrocknet.

Die so erhaltenen strukturierten Polymerschichten werden im elektrischen Feld, z. B. unter Verwendung eines Gleichspannungsfeldes zur Orientierung der chromophoren Struktureinheiten im Bereich der Glastemperatur gepolt und bei angelegtem elektrischen Feld, vorzugsweise strahlenchemisch, z. B. durch Elektronenstrahlen vernetzt.

Zur Einebnung bzw. Einbettung der erzeugten Strukturen sind solche Polymeren geeignet, die eine unterschiedliche Löslichkeit zum strukturierten Polymeren besitzen. Als günstig erwies sich ein Copolymerisat aus Methacrylsäuremethylester und > 30, beispielsweise 25 bis 60, vorzugsweise 30 bis 50 Gew.-% Methacrylsäure. Dieses Copolymerisat ist löslich in alkoholischen Lösungsmitteln, besitzt eine ausgezeichnete Transparenz, Haftfestigkeit und eine hohe Glastemperatur.

Die nachfolgenden Beispiele sollen das Prinzip der Erfindung an 3 unterschiedlichen Azo-chromophoren Verbindungen verdeutlichen:

### Beispiel 1

20 g Methacrylsäureglycidylester werden in 120 g Aceton gelöst und in Gegenwart von 0,5 Gew.-%, bezogen auf Methacrylsäureglycidylester, Azoisobuttersäuredinitril unter Inertgasatmosphäre 12 h unter Rückfluß erwärmt. Anschließend wird das Polymerisat in 315 g Methanol ausgefällt und durch mehrmaliges Lösen in Aceton und Fällen in Methanol gereinigt. Das gereinigte Polymer wird ohne zu trocknen in 50 g Cyclohexanon gelöst, die restlichen Lösungsmittel an Methanol und Aceton durch Destillation im Vakuum entfernt und die cyclohexanonische Polymerlösung durch ein 0,2 µm Druckfilter filtriert. (Polymergehalt der Lösung 18 Gew.-%; Molmasse Mw = 78.000; Mn = 40 000; Mw/Mn = 1,95, Tg = 66°C.) Jeweils 10 g der Lösung werden mit 10 Gew.-%, bezogen auf Polymer, der chromophoren Verbindung (I), (II) oder (III) versetzt, durch ein 0,2 µm-Druckfilter filtriert und für die Rotationsbeschichtung (1500 U/min) von Glas-Substraten verwendet.

Die so beschichteten Substrate werden anschließend mit Elektronenstrahlen strukturmäßig bestrahlt, die eingestrahlte Struktur 30-50 sek in Methylethylketon entwickelt und bei 60°C im Vakuum thermisch behandelt.

| Chromophor | Schichtdicke nm | Dosis C/cm² | Verbleibende Schicht % |
|---|---|---|---|
| (I) | 1250 | 1 x 10⁻⁵ | 82 |
| (II) | 1050 | 8 x 10⁻⁶ | 78 |
| (III) | 1270 | 9 x 10⁻⁶ | 85 |

### Beispiel 2

20 g eines isomeren Benzoldicarbonsäurediallylesters (Phalsäure-, Isophthalsäure- und Terephthalsäurediallylester) werden in Gegenwart von 1 % Benzoylperoxid unter Stickstoff bei 80°C zu einem noch löslichen verzweigten Prepolymeren polymerisiert. Das Prepolymere wird vom noch vorhandenen Monomeren durch Lösen in 160 g Aceton und anschließender Fällung mit 240 g Methanol abgetrennt. Durch mehrmaliges Umfällen in Aceton und Methanol wird das Prepolymer gereinigt und bei 60°C getrocknet.

| Prepolymer | Umsatz % | JZ²⁾ | -C=C Monomereinheit ³⁾ | Tg °C Prepolym. | Tg/°C⁴⁾ |
|---|---|---|---|---|---|
| PDAP | 21 | 55 | 1,4 | 63 | 95 |
| PDAIP | 15 | 81 | 1,2 | 74 | 105 |
| PDATP | 13 | 80 | 1,2 | 106 | 130 |
| PDATP/AMTP¹⁾ | 14 | | 1,3 | 57 | 103 |

| | | | | | |
|---|---|---|---|---|---|
| ¹⁾ Copolymer aus Terephthalsäurediallylester und Terephthalsäuremethylester (84/16 Gew.-%) | | | | | |
| ²⁾ Jodzahl (Jodmenge in g/100 g Polymer) | | | | | |
| ³⁾ Umsatz an Doppelbindungen je Monomereinheit | | | | | |
| ⁴⁾ Tg = Glastemperatur nach thermischer Behandlung (1 h bei 80°C) | | | | | |

Jeweils 5 g eines Prepolymeren (PDATP) werden in 20 g Cyclohexanon gelöst und 10 Gew.-%, bezogen auf den Polymergehalt, einer chromophoren Verbindung (I), (II) oder (III) hinzugegeben, durch ein 0,5 µm-Druckfilter filtriert und so für die Rotationsbeschichtung (1500 U/min) von Substraten verwendet. Die beschichteten Substrate werden anschließend mit Elektronenstrahlen strukturmäßig bestrahlt und die eingestrahlte Struktur in 15-30 sek in Methylethylketon entwickelt.

| Chromophor | Schichtdicke nm | Dosis C/cm² | Verbleibende Schicht % |
|---|---|---|---|
| (I) | 1520 | 8 x 10⁻⁵ | 75 |
| (II) | 1620 | 6 x 10⁻⁵ | 82 |
| (III) | 1830 | 5 x 10⁻⁵ | 85 |

### Beispiel 3

10 g eines Monomergemisches aus 8,4 g Terephthalsäurediallylester, 1,6 g Terephthalsäureallylmethylester und 0,5 g 4-(N-2-methacryloxyethyl-N-ethyl)-amino-4'-nitroazobenzol (I) werden in Gegenwart von 0,3 g Dibenzoylperoxid 8 Stunden bei 60°C unter Inertgasatmosphäre behandelt. Nach Abkühlung wurde das Prepolymer in 160 g Methanol gefällt, durch mehrmaliges Lösen in Aceton und Fällen in Methanol gereinigt und bei 60°C im Vakuum 3 Stunden getrocknet. Das Prepolymer ist löslich in Tetrahydrofuran, Cyclohexanon und Ethylglykolacetat und enthält einen Anteil des Azo-Monomeren von 3,95 Gew.-% (λₘₐₓ in THF 455 nm, Tg 50°C). Unter analogen Bedingungen erfolgt die Herstellung eines Prepolymeren mit 0,5 g 2,2'-Bis(methacryloxy)-4-diethylamino-4'-nitroazobenzol (II). Das Prepolymer enthält einen Anteil des Azomonomeren von 12,5 Gew.-% (λₘₐₓ in THF 472 nm; Tg 50°C).

### Beispiel 4

2 g Glycidylmethacrylat und 200 mg des chromophoren Azomonomeren (III) werden in 40 g Aceton gelöst und nach Zugabe von 22 mg Azoisobuttersäuredinitril (AIBN) 20 h unter Rückfluß und Stickstoffatmosphäre polymerisiert. Nach Zugabe von weiteren 22 mg AIBN wird die Polymerisation noch 15 Stunden weitergeführt. Das tief dunkelblau gefärbte Polymerisat wird in Diethylether gefällt. Durch mehrmaliges Lösen in Aceton und Fällen in Ether wird das Polymerisat in einer Ausbeute von 85 % erhalten. Aus der Elementaranalyse ergibt sich ein Copolymerisationsverhältnis von 90 : 10 Gew.-%; Tg 77°C.

### Beispiel 5

5 g der nach Beispiel 3 bzw. 4 hergestellten Copolymerisate werden in 25 g Cyclohexanon gelöst und nach Filtration durch ein 0,5 µm-Druckfilter für die Beschichtung von ITO-Substraten (ITO = Indium-Zinn-Oxid) (5 x 5 cm) verwendet. Nach einer bildmäßigen Elektronenbestrahlung (1,0 µm-Strukturen) werden die eingestrahlten Strukturen mit Methylethylketon entwickelt. Die erhaltenen Strukturen werden im elektrischen Feld 10-15 min bei 10 KV und 50°C im Falle des nach Beispiel 3 hergestellten Copolymerisats, bzw. bei 80°C im Falle des nach Beispiel 4 hergestellten Copolymerisats gepolt und durch Erhöhung der Temperatur bis auf 180°C bei angelegtem elektrischen Feld vernetzt.

| Copolymer | Schichtdicke [nm] | Dosis µC/cm² | Verbleibende Schichtdicke % |
|---|---|---|---|
| Bsp. 3 | 1280 | 60 | 65 |
| Bsp. 4 | 1150 | 20 | 78 |

### Beispiel 6

Eine Einebnung der nach Beispiel 5 hergestellten Strukturen vor der Polung im elektrischen Feld wird mit einem Copolymerisat aus Methacrylsäuremethylester und Methacrylsäure (Zusammensetzung: 66 : 34 Mol.-%, Mw = 128.000; Mn = 62.000; Mw/Mn = 1,5; Tg = 78°C; Lösungsmittel: Methylglykol, Polymergehalt 10 %) vorgenommen. Es wird dabei eine Schichtdicke von 1500 nm durch Rotationsbeschichtung bei 1500 U/min erhalten, indem die entwickelten Strukturen auf dem Substrat mit einer Copolymerlösung in Methylglykol beschichtet und 1 h bei 80°C im Vakuum thermisch behandelt werden.

### Beispiel 7

Die nach Beispiel 1 - 4 hergestellten Polymerschichten auf Substratmaterialien werden im Bereich der Glastemperatur des Polymersystems einer elektrischen Polung unterworfen und anschließend flächenmäßig oder bildmäßig mit einer Elektronenstrahlung der Dosis > 100 µC/cm² vernetzt.
Gast/Wirt-Systeme (Beispiel 1) 200 µC/cm²
Gast/Wirt-Systeme (Beispiel 2) 800 µC/cm²
Copolymersysteme (Beispiel 3) 600 µC/cm²
Copolymersysteme (Beispiel 4) 300 µC/cm²

## Patentansprüche

1. Verfahren zur Herstellung von strukturierten Polymerschichten mit nichtlinear optischen Eigenschaften, dadurch gekennzeichnet, daß man entweder ethylenisch ungesättigte Gruppierungen enthaltende organische Verbindungen mit ethylenisch ungesättigte Gruppierungen sowie Donator- und Acceptorgruppen enthaltenden Stilben-, Azo- oder Azomethinverbindungen radikalisch copolymerisiert (A) oder ethylenisch ungesättigte Gruppierungen enthaltende organische Verbindungen radikalisch polymerisiert und mit ethylenisch ungesättigte Gruppierungen sowie Donator- und Acceptorgruppen enthaltenden Stilben-, Azo- oder Azomethinverbindungen vermischt (B), die so erhaltenen Copolymerisate (A) bzw. Gemische (B) mit hochenergetischer Strahlung bildmäßig bestrahlt, die unbestrahlten Bereiche entfernt und die so erhaltenen strukturierten Polymerschichten im elektrischen Feld zur Orientierung der chromophoren Struktureinheiten im Bereich der Glastemperatur des Polymers polt und bei angelegtem elektrischem Feld vernetzt.

2. Verfahren nach Anspruch 1, dadurch gekennzeichnet, daß als hochenergetische Strahlung Elektronen-, Röntgen- oder Ionenstrahlung eingesetzt wird.

3. Verfahren nach Anspruch 1 oder 2, dadurch gekennzeichnet, daß zur Herstellung der Copolymerisate (A) bzw. der Gemische (B) Methacrylsäureglycidylester oder Benzoldicarbonsäurediallylester eingesetzt wird.

4. Verfahren nach einem der vorhergehenden Ansprüche, dadurch gekennzeichnet, daß die Vernetzung bei angelegtem elektrischen Feld strahlenchemisch erfolgt.

5. Verfahren zur Weiterverarbeitung strukturierter Polymerschichten mit nichtlinear optischen Eigenschaften zu optischen Wellenleitern, dadurch gekennzeichnet, daß die gemäß einem Verfahren nach einem der vorhergehenden Ansprüche hergestellten strukturierten Polymerschichten vor oder nach der Polung im elektrischen Feld und Vernetzung durch Aufbringen eines Copolymerisats aus Methacrylsäuremethylester und Methacrylsäure, wobei der Methacrylsäureanteil im Copolymerisat > 30 Mol.-% beträgt, eingeebnet werden.
